(19) Europäisches Patentamt
European Patent Office
Office européen des brevets

(11) **EP 4 055 670 B1**

(12) **FASCICULE DE BREVET EUROPEEN**

(45) Date de publication et mention de la délivrance du brevet:
**06.09.2023 Bulletin 2023/36**

(21) Numéro de dépôt: **20799717.2**

(22) Date de dépôt: **04.11.2020**

(51) Classification Internationale des Brevets (IPC):
**H01S 5/02** *(2006.01)*   **H01S 5/06** *(2006.01)*
**H01S 5/065** *(2006.01)*   **H01S 5/10** *(2021.01)*
**H01S 5/12** *(2021.01)*   **H01S 5/20** *(2006.01)*
**H01S 5/22** *(2006.01)*

(52) Classification Coopérative des Brevets (CPC):
**H01S 5/0657; H01S 5/021; H01S 5/0602;
H01S 5/1003; H01S 5/101; H01S 5/1032;
H01S 5/12; H01S 5/1206; H01S 5/1225;
H01S 5/2022; H01S 5/22**

(86) Numéro de dépôt international:
**PCT/EP2020/080985**

(87) Numéro de publication internationale:
**WO 2021/089635 (14.05.2021 Gazette 2021/19)**

(54) **LASER À VERROUILLAGE DE MODE À ORIFICES ET COMPOSANT OPTIQUE ASSOCIÉ**

MODENGEKOPPELTER LASER MIT ÖFFNUNGEN UND ZUGEHÖRIGE OPTISCHE KOMPONENTE

ORIFICE-COMPRISING MODE-LOCKED LASER AND ASSOCIATED OPTICAL COMPONENT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **07.11.2019 FR 1912504**

(43) Date de publication de la demande:
**14.09.2022 Bulletin 2022/37**

(73) Titulaires:
- **THALES**
  **92400 Courbevoie (FR)**
- **Centre National de la Recherche Scientifique**
  **75016 Paris (FR)**
- **Université Paris Cité**
  **75006 Paris (FR)**

(72) Inventeurs:
- **DE ROSSI, Alfredo**
  **91767 Palaiseau Cedex (FR)**
- **COMBRIE, Sylvain**
  **91767 Palaiseau Cedex (FR)**
- **RAINERI, Fabrice**
  **75013 Paris (FR)**

(74) Mandataire: **Lavoix**
  **2, place d'Estienne d'Orves**
  **75441 Paris Cedex 09 (FR)**

(56) Documents cités:
**WO-A1-2012/058742    WO-A1-2016/207495**

- **Y. HALIOUA ET AL: "Hybrid III-V semiconductor/silicon nanolaser", OPTICS EXPRESS, vol. 19, no. 10, 9 mai 2011 (2011-05-09), page 9221, XP055250887, US ISSN: 2161-2072, DOI: 10.1364/OE.19.009221**
- **BAZIN ALEXANDRE ET AL: "Design of Silica Encapsulated High-Q Photonic Crystal Nanobeam Cavity", JOURNAL OF LIGHTWAVE TECHNOLOGY, IEEE, USA, vol. 32, no. 5, 1 mars 2014 (2014-03-01), pages 952-958, XP011537190, ISSN: 0733-8724, DOI: 10.1109/JLT.2013.2295267 [extrait le 2014-01-13]**

EP 4 055 670 B1

## Description

La présente invention concerne un laser à verrouillage de mode, ainsi qu'un composant optique comprenant un tel laser.

L'invention se situe dans le domaine de la photonique intégrée, qui concerne la miniaturisation de composants optiques sur des circuits intégrés.

La photonique intégrée s'est développée sur des substrats comme le verre, le silicium ou les matériaux III-V. On utilise les matériaux III-V pour réaliser les sources laser semi-conducteur. On rappelle qu'un semi-conducteur de type « III - V » est un semi-conducteur composite fabriqué à partir d'un ou plusieurs éléments de la colonne III du tableau périodique des éléments (bore, aluminium, gallium, indium, ...) et d'un ou plusieurs éléments de la colonne V ou pnictogènes (azote, phosphore, arsenic, antimoine ...).

Il est souhaitable d'utiliser plutôt des substrats en silicium puisque les substrats en silicium permettent d'intégrer à la fois des composants optiques et des composants électroniques. Par ailleurs, ce choix permet l'utilisation d'une infrastructure existante qui est très performante pour la production industrielle.

Une source laser intégrée sur un circuit photonique présente généralement des dimensions micrométriques, c'est-à-dire dont les dimensions sont comprises entre un micron et un millimètre.

Notamment, de telles sources ont des applications notamment dans le domaine des télécommunications, où le débit de données est un paramètre qu'il est souhaitable d'améliorer, ainsi qu'en métrologie, où l'émission d'impulsions laser de courte durées et avec une haute fréquence de répétition permettent d'obtenir des précisions très élevées.

La miniaturisation des lasers à verrouillage de mode, typiquement en matériau III-V, et leur intégration sur puce photonique en silicium est un sujet de recherche appliquée très actif car il répond à un besoin important.

En effet, un laser à verrouillage de mode est propre à émettre des impulsions comprenant une pluralité de modes synchronisés en phase. Une telle source impulsionnelle à verrouillage de phase permet d'émettre des impulsions de très courte durée avec un très faible temps de répétition, afin d'atteindre des fréquences d'émission très élevées et donc des débits de données importants.

Un exemple de source laser micrométrique sur puce photonique est décrit par le document WO 2016/207495.

Le laser décrit dans ce document comprend un support sur lequel s'étend une nervure constituée d'un empilement de couches successives de matériaux semi-conducteur de type III-V. La nervure est de plus percée de trous s'étendant sur toute sa hauteur, alignés régulièrement selon la direction d'étendue de la nervure.

Les diamètres et espacements des trous sont prévus de sorte que chaque série de trous forme un miroir pour les ondes électromagnétiques.

La nervure présente en outre deux prolongements latéraux métallisés, permettant de réaliser le pompage optique.

Cependant, la source décrite dans ce document ne donne pas entière satisfaction. En effet, cette source laser ne permet pas l'émission d'impulsions laser multimodes synchronisées en phase.

Il existe donc un besoin pour la réalisation d'une source impulsionnelle à verrouillage de mode, intégrée sur une puce photonique et présentant une faible consommation énergétique.

A cet effet, il est proposé un laser à verrouillage de mode comprenant :

- un substrat isolant,
- une nervure s'étendant sur le substrat selon une direction d'étendue, la nervure formant une cavité résonante pour au moins une onde électromagnétique,
- un guide d'ondes défini dans le substrat, s'étendant selon une direction de guidage,

  la cavité étant propre à accueillir une pluralité de modes de résonnance équidistants en fréquence, la nervure comprenant une couche inférieure, une pluralité de couches intermédiaires et une couche supérieure, empilées selon une direction d'empilement orthogonale à la direction d'étendue, la nervure présentant une pluralité d'orifices traversants alignés selon la direction d'étendue, le guide d'ondes étant séparé de la nervure par une distance non nulle selon la direction d'empilement, chaque orifice étant séparé de chaque orifice voisin par un écartement, les écartements présentant chacun une dimension, mesurée selon la direction d'étendue, qui varie selon la direction d'étendue selon une loi de variation, la loi de variation étant une fonction polynomiale symétrique d'ordre supérieur ou égal à quatre d'une position de l'écartement selon la direction d'étendue.

Selon des modes de réalisation particuliers, le laser présente l'une ou plusieurs des caractéristiques suivantes, prise(s) isolément ou selon toute combinaison techniquement réalisable :

- la fonction polynomiale est d'ordre quatre, et est décrite par une formule du type :

$$a_n = a(x_n) = a_0 + A x_n{}^2 + B x_n{}^4$$

où :

- $a_n$ est la dimension de l'écartement séparant un des orifices, référencé par un indice n, de l'orifice voisin, référencé par un indice n+1,

- $x_n$ est la distance entre un orifice, référencé par l'indice 0, et l'orifice référencé par l'indice n, et
- A et B sont des constantes non-nulles,

- une valeur de A est choisie de manière à fixer une valeur d'un intervalle spectral libre de la cavité, une valeur de B étant choisie pour permettre d'obtenir les modes de résonance équidistants en fréquence de la cavité,
- la cavité présente une longueur mesurée selon la direction d'étendue, la longueur de la cavité étant suffisante pour que la cavité soit apte à accueillir au moins six modes de résonnance équidistants en fréquence, la longueur de la cavité étant notamment supérieure ou égale à 20 micromètres,
- la couche inférieure définit, selon une direction transversale, des prolongements latéraux s'étendant de part et d'autre des couches intermédiaires et de la couche supérieure, chaque prolongement latéral recevant au moins un contact électrique,
- chaque prolongement latéral comprend un sillon isolant s'étendant à travers le prolongement latéral selon la direction transversale, de manière à diviser le prolongement latéral en deux régions voisines selon la direction d'étendue, isolées électriquement l'une de l'autre, chaque région recevant un contact électrique respectif distinct,
- la nervure comprend également une première couche absorbante s'étendant en-dessous de la couche inférieure selon la direction d'empilement, et une deuxième couche absorbante s'étendant au-dessus de la couche supérieure selon la direction d'empilement, la première couche absorbante et la deuxième couche absorbante comprenant un matériau absorbant saturable à au moins une fréquence de résonance de la nervure,
- la direction de guidage forme un angle de couplage non-nul avec la direction d'étendue, dans le plan horizontal, et
- le guide d'ondes présente une largeur variable le long de la direction de guidage, mesurée selon une direction orthogonale à la direction de guidage.

La présente description concerne également un composant optique comprenant un laser tel que décrit précédemment.

L'invention sera mieux comprise à la lecture de la description qui suit, donnée uniquement à titre d'exemple et faite en référence aux dessins annexés, parmi lesquels :

- [Fig 1] la figure 1 est une vue en perspective schématique simplifiée d'un exemple de laser;
- [Fig 2] la figure 2 est une vue en coupe transversale du laser de la figure 1 ;
- [Fig 3] la figure 3 est une vue de dessus d'une partie du laser de la figure 1 ;
- [Fig 4] la figure 4 est une représentation graphique d'un spectre d'émission du laser représenté aux figures 1 à 3, et
- [Fig 5] la figure 5 est une vue de dessus schématique d'un autre exemple de laser.

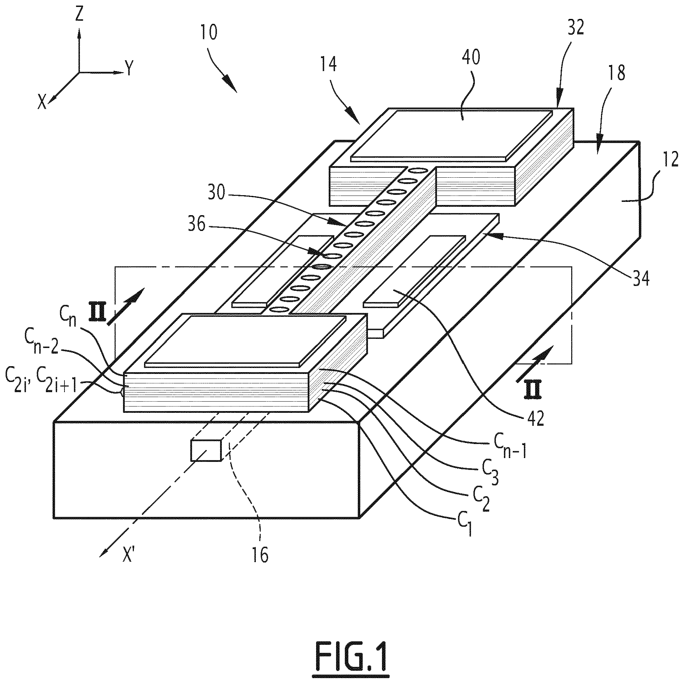

Un laser 10 est représenté sur les figures 1 à 3.

Par le terme « laser », il est entendu un système photonique qui produit un rayonnement lumineux spatialement et temporellement cohérent basé sur l'effet laser (acronyme issu de l'anglais light *amplification by stimulated émission of radiation* qui signifie « amplification de la lumière par émission stimulée de radiation »).

Une source laser associe un amplificateur optique à une cavité optique dans laquelle le rayonnement lumineux est partiellement confiné, encore appelée résonateur. A chaque parcours de la cavité par le rayonnement lumineux, une partie de la lumière sort de la cavité et l'autre partie est réinjectée vers l'intérieur de la cavité et l'amplificateur pour être amplifiée.

Le laser 10 est un laser à verrouillage de mode, c'est-à-dire apte à émettre des ondes électromagnétiques formant des impulsions laser cohérentes synchronisées en phase.

Le laser 10 est, de plus, apte à émettre des impulsions laser multimodes, c'est-à-dire des ondes impulsionnelles présentant un grand nombre de modes équi-espacés en fréquence optique, dans une bande de fréquence d'intérêt.

Le laser 10 comprend un substrat 12, une nervure 14 et un guide d'ondes 16.

La laser 10 est décrit en référence à une direction d'étendue X, une direction transversale Y et une direction d'empilement Z, orthogonales les unes aux autres.

Dans tout ce qui suit, par l'expression « compris entre deux valeurs », il est entendu un encadrement au sens large, c'est-à-dire incluant les valeurs des bornes.

Le substrat 12 est une couche formant une plaque. Le substrat 12 est réalisé en matériau isolant électriquement, et ne conduit donc pas le courant électrique.

Selon l'exemple représenté, le matériau isolant électriquement est un oxyde de silicium.

Le matériau isolant composant le substrat 12 est perméable au rayonnement lumineux, et présente un indice de réfraction.

L'indice de réfraction du matériau isolant est, par exemple, compris entre 1,3 et 1,7.

Le substrat 12 présente une face supérieure 18 s'étendant dans un plan horizontal XY.

La face supérieure 18 est la limite supérieure d'une couche constituée par le substrat 12.

Le substrat 12 porte la nervure 14 sur la face supérieure 18.

Le guide d'ondes 16 s'étend dans le substrat 12, à l'écart de la face supérieure 18. Le guide d'ondes 16 est ainsi un guide d'ondes enfoui dans le substrat 12.

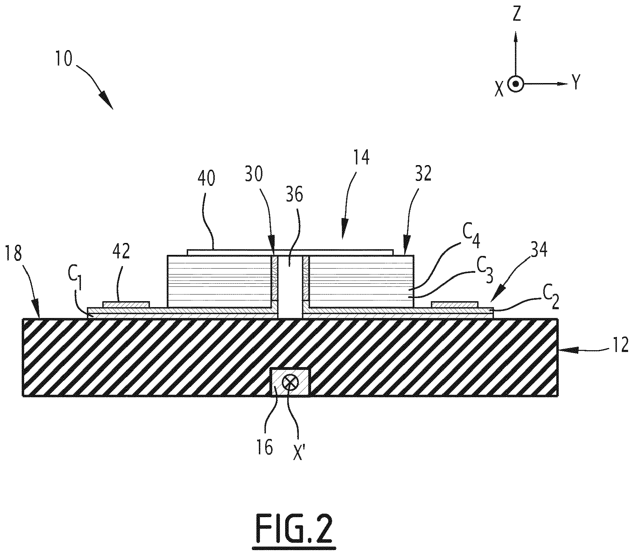

Comme représenté sur la figure 2, la nervure 14 est une structure multicouche en contact avec la face supérieure 18 du substrat 12. Autrement dit, la nervure 14 comprend une pluralité de couches planaires et superposées, qui reposent sur le substrat 12.

Dans l'exemple présenté, la nervure 14 comprend N couches $C_k$ superposées, l'indice k variant de 1 à N.

Les couches $C_k$ sont empilées suivant la direction d'empilement Z.

La couche $C_1$ portant l'indice k = 1 est la couche s'étendant sur la face supérieure 18 du substrat 12.

L'indice k augmente d'une couche $C_k$ à la suivante $C_{k+1}$ selon la direction d'empilement Z.

Chaque couche $C_k$ présente une épaisseur $e_k$, mesurée selon la direction d'empilement Z.

Chaque couche $C_k$ est réalisée à partir d'un matériau $M_k$.

La couche $C_1$ est une première couche absorbante et la couche $C_N$ est une deuxième couche absorbante.

Les épaisseurs $e_1$ et $e_N$ sont comprises entre 5 nanomètres et 10 nanomètres.

Le matériau $M_1$, $M_N$ est un matériau absorbant saturable, c'est-à-dire un matériau dont le coefficient d'absorption d'une onde électromagnétique qui le traverse décroit quand l'intensité de l'onde augmente, au moins pour des fréquences de la plage de fréquences d'intérêt.

Le matériau $M_1$, $M_N$ est, par exemple, le graphène.

Selon un mode de réalisation, le matériau $M_1$, $M_N$ est un matériau semi-conducteur de type III-V, comme défini précédemment.

Par exemple, le matériau $M_1$, $M_N$ est le l'arséniure phosphure de gallium d'indium, aussi noté InGaAsP ou l'arséniure de gallium d'indium, aussi noté InGaAs, avec une composition d'alliage ajustées pour avoir une absorption satisfaisante sur la plage de fréquences d'intérêt.

La couche $C_2$ est une couche inférieure, dopée de type P.

L'épaisseur $e_2$ est comprise entre 50 et 250 nanomètres, de préférence entre 100 et 150 nanomètres, par exemple égale à 130 nanomètres.

Le matériau $M_2$ est un matériau semi-conducteur de type III-V, comme défini précédemment.

Par exemple, le matériau $M_2$ est l'arséniure phosphure de gallium d'indium, InGaAsP.

Le matériau $M_2$ comprend entre 0% et 40% de gallium et entre 60% et 100% d'indium, par exemple 20% de gallium et 80% d'indium, en masse, relativement à la masse totale de gallium et d'indium.

Le matériau $M_2$ comprend également entre 0% et 60% de phosphore et entre 40% et 100% d'arsenic, par exemple 55% de phosphore et 45% d'arsenic, en masse, relativement à la masse totale de phosphore et d'arsenic.

Par « dopée de type P », il est entendu que la couche $C_2$ comprend des impuretés électropositives ajoutées en petite quantité dans le matériau $M_2$.

Par le terme « électropositives », il est entendu que les impuretés induisent un déficit d'électrons dans la couche $C_2$.

Par exemple, les impuretés électropositives sont des atomes de zinc, introduits avec une proportion volumique de l'ordre de $10^{18}$ atomes/$cm^3$.

La couche $C_{N-1}$ est une couche supérieure.

La couche supérieure est dopée de type N.

L'épaisseur $e_{N-1}$ est comprise entre 50 nanomètres et 250 nanomètres, de préférence entre 100 nanomètres et 150 nanomètres, par exemple égale à 150 nanomètres.

Le matériau $M_{N-1}$ est un matériau semi-conducteur de type III-V.

Par exemple, le matériau $M_{N-1}$ est le phosphure d'indium, aussi noté InP.

Par « dopée de type N », il est entendu que la couche $C_{N-1}$ comprend des impuretés électronégatives ajoutées en petite quantité dans le matériau $M_{N-1}$.

Par le terme « électronégatives », il est entendu que les impuretés induisent un excès d'électrons dans la couche $C_{N-1}$.

Par exemple, les impuretés électronégatives sont des atomes de silicium, introduits avec une proportion volumique de l'ordre de $10^{18}$ atomes/$cm^3$.

Les couches $C_3$ à $C_{N-2}$ sont des couches intermédiaires.

Parmi les couches intermédiaires, la couche $C_3$ est une première couche intrinsèque et la couche $C_{N-2}$ est une deuxième couche intrinsèque.

Par le terme « instrinsèque », il est entendu que les couches $C_3$ et $C_{N-2}$ sont des couches non-dopées, voisines de couches dopées de type P et N respectivement.

L'épaisseur $e_3$ et l'épaisseur $e_{N-2}$ sont comprises entre 15 nanomètres et 100 nanomètres, de préférence entre 15 nanomètres et 60 nanomètres, par exemple égales à 40 nanomètres.

Le matériau $M_3$ et le matériau $M_{N-2}$ sont des matériaux semi-conducteurs de type III-V.

Le matériau $M_3$ et le matériau $M_{N-2}$ sont, par exemple, de l'arséniure phosphure de gallium d'indium, InGaAsP.

Le matériau $M_3$ et le matériau $M_{N-2}$ comprennent entre 0% et 40% de gallium et entre 60% et 100% d'indium, par exemple 16% de gallium et 84% d'indium, en masse, relativement à la masse totale de gallium et d'indium.

Le matériau $M_3$ et le matériau $M_{N-2}$ comprennent également entre 0% et 60% de phosphore et entre 40% et 100% d'arsenic, par exemple 52% de phosphore et 48% d'arsenic, en masse, relativement à la masse totale de phosphore et d'arsenic.

Les couches $C_4$ à $C_{N-3}$ sont des couches médianes.

Les couches médianes comprennent des couches d'indice pair $C_{2i}$ identiques entre elles et des couches d'indice impair $C_{2i+1}$ identiques entre elles.

Les épaisseurs $e_{2i}$ sont comprises entre 4 nanomètres et 12 nanomètres, par exemple égales à 6,5 nanomètres.

Les épaisseurs $e_{2i+1}$ sont comprises entre 10 nanomètres et 50 nanomètres, de préférence entre 10 nanomètres et 20 nanomètres, par exemple égales à 15 nanomètres.

Les matériaux $M_{2i}$ et $M_{2i+1}$ des couches médianes sont des matériaux semi-conducteurs de type III-V.

Les matériaux $M_{2i}$ et $M_{2i+1}$ sont choisis de façon à ce que les couches d'indice pair $C_{2i}$ forment des puits quantiques.

Par le terme « puits quantiques », on désigne des zones de faible dimension dans une structure hétérogène d'un semi-conducteur présentant un potentiel plus faible, pour confiner les électrons. Le mouvement des électrons est alors discrétisé dans la direction d'empilement Z, ce qui permet l'apparition de bandes d'énergie.

Le matériaux $M_{2i}$ est, par exemple, l'arséniure phosphure de gallium d'indium, InGaAsP.

Le matériau $M_{2i}$ comprend entre 0% et 40% de gallium et entre 60% et 100% d'indium, par exemple 16% de gallium et 84% d'indium, en masse, relativement à la masse totale de gallium et d'indium.

Le matériau $M_{2i}$ comprend également entre 0% et 30% de phosphore et entre 70% et 100% d'arsenic, par exemple 24% de phosphore et 76% d'arsenic, en masse, relativement à la masse totale de phosphore et d'arsenic.

Le matériau $M_{2i+1}$ est, par exemple, également l'arséniure phosphure de gallium d'indium, InGaAsP, avec une composition différente de celle du matériau $M_{2i}$.

Le matériau $M_{2i+1}$ comprend entre 5% et 40% de gallium et entre 60% et 95% d'indium, par exemple 16% de gallium et 84% d'indium, en masse, relativement à la masse totale de gallium et d'indium.

Le matériau $M_{2i+1}$ comprend également entre 0% et 60% de phosphore et entre 40% et 100% d'arsenic, par exemple 52% de phosphore et 48% d'arsenic, en masse, relativement à la masse totale de phosphore et d'arsenic.

La nervure 14 comprend une partie centrale 30, deux parties extrémales 32, deux prolongements latéraux 34, ainsi qu'une pluralité d'orifices 36.

La nervure 14 est agencée pour former un guide optique dans lequel se propage au moins une onde électromagnétique présentant des fréquences parmi une plage de fréquences d'intérêt.

La nervure 14 constitue une cavité résonante pour l'onde électromagnétique, c'est à dire un milieu de propagation confinée de l'onde électromagnétique.

Les matériaux $M_k$ composant la nervure 14 sont perméables au rayonnement lumineux, et présentent des indices de réfraction respectifs.

Les indices de réfraction des matériaux de la nervure 14 sont, par exemple, supérieurs à 3.

La nervure 14 présente un gain d'intensité pour certaines fréquences de l'onde.

La partie centrale 30 est une partie rectiligne s'étendant selon la direction d'étendue X.

Ainsi, la partie centrale 30 présente une forme parallélépipédique, allongée selon la direction d'étendue X.

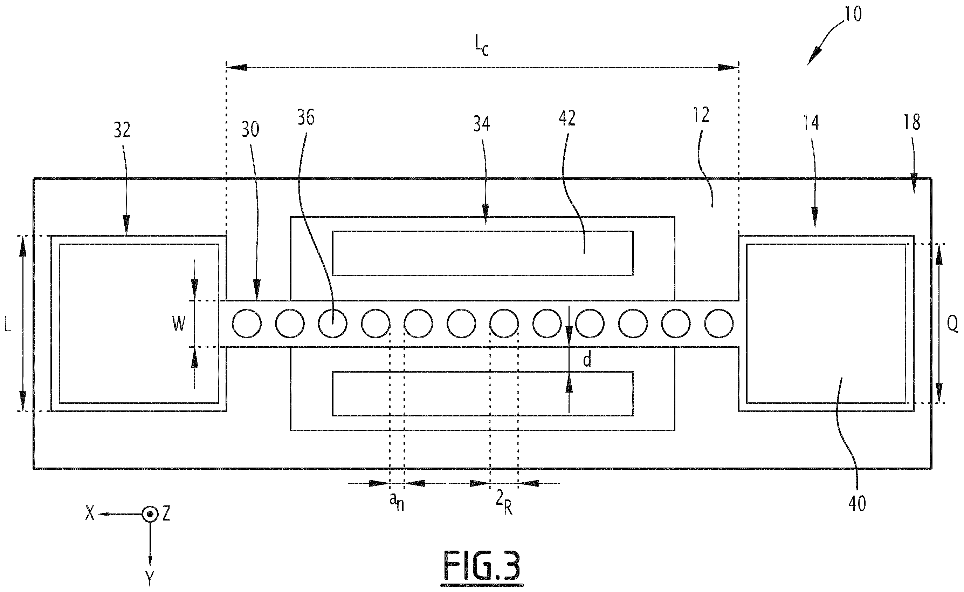

Selon l'exemple présenté, la partie centrale 30 présente, comme représenté sur la figure 3, une longueur $L_c$, mesurée selon la direction d'étendue X.

La longueur $L_c$ de la partie centrale 30 est suffisante pour que la cavité résonnante formée par la nervure 14 puisse accueillir un nombre prédéterminé de modes de résonance, dont un mode fondamental présentant une largeur à mi-hauteur.

Par le terme « largeur à mi-hauteur », il est entendu, pour une variable dépendante qui varie selon une variable indépendante, suivant une courbe présentant une valeur maximale, la différence entre les deux valeurs extrêmes de la variable indépendante pour lesquelles la variable dépendante est égale à la moitié de la valeur maximale.

Dans le cas présent, la variable indépendante est une fréquence d'une onde électromagnétique et la variable dépendante une intensité de l'onde électromagnétique à cette fréquence.

Par exemple, la cavité est adaptée pour accueillir plus de dix modes de résonance, autour d'un mode fondamental pour lequel la largeur à mi-hauteur est égale à 5 micromètres.

Dans ce cas, la longueur $L_c$ de partie centrale 30 est supérieure ou égale à 50 micromètres, notamment supérieure ou égale à 100 micromètres.

La partie centrale 30 présente également une largeur W, mesurée selon la direction transversale Y, constante sur toute l'étendue de la partie centrale 30.

La largeur W est, par exemple, comprise entre 5 micromètres et 15 micromètres.

Les parties extrémales 32 sont des parties situées de part et d'autre de la partie centrale 30 selon la direction d'étendue X.

Les parties extrémales 32 présentent chacune une forme parallélépipédique.

Selon l'exemple représenté, les parties extrémales 32 sont identiques l'une à l'autre.

Les parties extrémales 32 présentent des largeurs L, mesurées selon la direction transversale Y, plus importantes que la largeur W de la partie centrale.

La largeur L de chaque partie extrémale 32 est, par exemple, comprise entre 20 micromètres et 30 micromètres.

Chaque partie extrémale 32 comprend un contact supérieur 40, s'étendant sur la couche $C_N$.

Les contacts supérieurs 40 sont des métallisations destinées à recevoir une électrode afin de les porter à un premier potentiel électrique et de faire circuler un courant électrique dans la nervure 14.

Les contacts supérieurs 40 sont, par exemple, de forme rectangulaire.

Chaque contact supérieur 40 présente une largeur Q, mesurée selon la direction transversale Y, supérieure à la largeur W de la partie centrale 30, et inférieure à la largeur L de la partie extrémale 32. Cela permet notamment de diminuer la résistance électrique du contact supérieur 40.

Les contacts supérieurs 40 sont réalisés en un premier matériau métallique.

Le premier matériau métallique est, par exemple, l'or ou le titane.

Les prolongements latéraux 34 sont des extensions de la couche inférieure $C_2$ sur la face supérieure 18 du substrat 12.

Les prolongements latéraux 34 font saillie depuis la partie centrale 30 et s'étendent de part et d'autre de la partie centrale 30 selon la direction transversale Y.

Les prolongements latéraux 34 présentent chacun une forme rectangulaire aplatie dans un plan horizontal XY.

La couche inférieure $C_2$ s'étend sur le substrat 18 depuis la partie centrale pour former les prolongements latéraux 34.

Les prolongements latéraux 34 sont disjoints des parties extrémales 32.

Chaque prolongement latéral 34 comprend un contact latéral 42 sur une face supérieure.

Chaque prolongement latéral 34 a une épaisseur mesurée selon la direction d'empilement Z.

L'épaisseur de chaque prolongement latéral 34 est inférieure à l'épaisseur $e_2$.

Par exemple, l'épaisseur des prolongements latéraux 34 est comprise entre deux tiers et la moitié de $e_2$.

Les contacts latéraux 42 sont des sites de réception d'une électrode, destinée à porter le contact latéral 42 à un deuxième potentiel électrique différent du premier potentiel électrique, afin de faire circuler un courant électrique dans la nervure 14.

Les contacts latéraux 42 sont symétriques l'un à l'autre par rapport à la partie centrale 30 de la nervure 14.

Les contacts latéraux 42 sont réalisés en un deuxième matériau métallique.

Le deuxième matériau métallique est, par exemple, l'or ou le zinc.

Chaque contact latéral 42 est séparé de la partie centrale 30 de la nervure par une distance d.

La distance d est mesurée selon la direction transversale Y, entre les points les plus proches du contact latéral 42 et de la partie centrale 30, comme représenté sur la figure 3.

La distance d est choisie pour minimiser une absorption dans les contacts latéraux 42 d'une onde électromagnétique se propageant dans la nervure 14, tout en maintenant une conduction suffisamment élevée entre les contacts latéraux 42 et la partie centrale 30.

La distance d est, par exemple, comprise entre 0,5 fois et 2 fois la longueur d'onde d'une onde de fréquence appartenant à la plage de fréquences d'intérêt, divisée par l'indice de réfraction du deuxième matériau métallique.

Les orifices 36 sont des perforations cylindriques traversantes dans la partie centrale 30 de la nervure 14.

Par le terme « traversant », il est entendu que chaque orifice 36 traverse toutes les couches de la nervure 14, selon la direction d'empilement Z, jusqu'à la face supérieure 18 du substrat 12.

Les orifices 36 sont alignés le long de la partie centrale 30.

Chaque orifice 36 présente une section circulaire et un diamètre 2r constant d'un orifice 36 à l'autre, comme représenté sur la figure 3.

Chaque orifice 36 s'étend selon un axe central parallèle à la direction d'empilement Z.

L'axe central s'étend dans un plan médian de la partie centrale 30, perpendiculaire à la direction transversale Y.

Le choix du diamètre 2r des orifices 36 par rapport à la largeur W de la partie centrale, ainsi que la répartition des orifices le long de partie centrale 30 permettent à la nervure 14 de former un cristal photonique.

Par le terme « cristal photonique », il est entendu une structure périodique de matériaux diélectriques, semi-conducteurs ou métallo-diélectriques modifiant la propagation des ondes électromagnétiques de la même manière qu'un potentiel périodique dans un cristal semi-conducteur affecte le déplacement des électrons en créant des bandes d'énergie autorisées et interdites.

Les orifices 36 sont référencés ci-après par un indice n, à partir d'un premier orifice portant l'indice n = 0, choisi à une extrémité de la partie centrale 30, le plus proche d'une des parties extrémales 32.

Chaque orifice 36 d'indice n est séparé de l'orifice suivant d'indice n+1 par un écartement. L'écartement séparant deux orifices 36 s'étend entre les deux points les plus proches des périphéries des deux orifices 36, comme représenté sur la figure 3.

Une dimension de l'écartement séparant l'orifice 36 d'indice n de l'orifice 36 d'indice n+1, mesurée selon la direction d'étendue X, est notée $a_n$.

La dimension $a_n$ varie d'un écartement à l'autre selon une loi de variation.

La loi de variation de la dimension $a_n$ selon la direction d'étendue X est choisie pour permettre le verrouillage de modes par le laser 10, c'est-à-dire pour que la nervure 14 présente plusieurs modes de résonance équi-espacés en fréquence.

La loi de variation est une fonction dont une variable est la position $x_n$ des orifices.

La position $x_n$ d'un orifice 36 d'indice n est la distance séparant l'axe de l'orifice 36 d'indice n de l'axe du premier orifice 36 d'indice n = 0.

La loi de variation est, par exemple, une fonction polynomiale.

Par exemple, la loi de variation est une fonction polynomiale symétrique, d'ordre au moins égal à 2.

Par le terme « symétrique », il est entendu que les termes d'ordre impair de la fonction polynomiale sont nuls.

Ainsi, une loi de variation envisageable est du type :

$$a_n = a(x_n) = \alpha x_n^2 + \beta$$

Où $\alpha$ et $\beta$ sont des constantes non nulles.

Selon l'exemple proposé, la loi de variation est une fonction polynomiale symétrique d'ordre 4.

Selon l'exemple proposé, la loi de variation s'exprime sous la forme :

$$a_n = a(x_n) = a_0 + A x_n^2 + B x_n^4$$

Où $a_0$ est la dimension de l'écartement séparant l'orifice 36 d'indice 0 de l'orifice 36 d'indice 1, et où A et B sont des constantes non nulles.

Les valeurs des constantes A et B sont choisies pour obtenir l'émission par le laser 10 d'une onde électromagnétique présentant des modes équi-espacés en fréquence.

Plus précisément, la valeur de A est choisie de manière à fixer une valeur d'un intervalle spectral libre de la nervure 14.

La valeur de B est choisie pour permettre d'obtenir les modes de résonance équidistants en fréquence de la nervure 14.

Les valeurs de $a_0$, A et B sont, par exemple, obtenues par une simulation numérique du fonctionnement du laser 10.

Par exemple, la valeur de $a_0$ est comprise entre 300 nanomètres et 400 nanomètres, plus particulièrement entre 330 nanomètres et 350 nanomètres.

Selon l'exemple représenté, la valeur de $a_0$ est choisie égale à 340 nanomètres.

Par exemple, la valeur de A est choisie entre 2 mètres$^{-1}$ et 3 mètres$^{-1}$, plus particulièrement entre 2,2 mètres$^{-1}$ et 2,4 mètres$^{-1}$.

Selon l'exemple représenté, la valeur de A est choisie égale à 2,3 mètres$^{-1}$.

Par exemple, la valeur de B est choisie entre $1,5 \times 10^7$ mètres$^{-3}$ et $2 \times 10^7$ mètres$^{-3}$.

Selon l'exemple représenté, la valeur de B est choisie égale à $1,8 \times 10^7$ mètres$^{-3}$.

Les valeurs de A et de B de l'exemple présenté ont été testées expérimentalement et permettent l'émission par le laser 10 d'impulsions multimodes verrouillées en phase.

Plus généralement, la cavité formée par la nervure 14 est adaptée pour accueillir un nombre $N_m$ de modes de résonnance, autour d'un mode fondamental pour lequel la largeur à mi-hauteur $X_0$, la longueur $L_c$ minimale de la partie centrale 30 est donnée par l'équation :

$$L_c = 2 X_0 \sqrt{N_m}$$

dans laquelle $X_0$ est obtenu par l'équation :

$$X_0 = \sqrt{\frac{2 V_g^2}{\Delta \omega_g * \Omega}}$$

où :

$V_g$ est la vitesse de groupe des ondes électromagnétiques dans la structure,

$\Delta \omega_g$ est la largeur spectrale de la réflectivité de la structure, et

$\Omega$ est l'écart spectral entre chacun des modes.

Par le terme « vitesse de groupe », il est entendu, pour une superposition d'ondes électromagnétiques, une vitesse de transmission d'un signal par la superposition de ces ondes.

$V_g$ est égale à la célérité de la lumière dans le vide, divisée par l'indice de réfraction des matériaux composant la nervure 14.

Par le terme « largeur spectrale de la réflectivité », il est entendu la largeur à mi-hauteur de la courbe représentant la réflectivité du réseau formé par les tranchées en fonction de la fréquence.

La réflectivité est le carré du rapport des amplitudes de l'onde réfléchie par une structure et de l'onde incidente sur la structure à une fréquence donnée.

$\Delta \omega_g$ est, dans l'exemple proposé, égale à $2\pi \times 40 \times 10^{12}$ hertz.

Par le terme « écart spectral entre les modes », il est entendu un écart de fréquence entre les fréquences pour lesquelles l'amplitude est maximale, pour deux modes successifs de la cavité.

$\Omega$ est, dans l'exemple représenté, égal à $2\pi \times 150$ gigahertz.

Le guide d'ondes 16 est un canal de silicium s'étendant à travers le substrat 12, selon une direction de guidage X'.

Le guide d'ondes 16 est propre à recueillir une partie de l'onde électromagnétique se propageant dans la nervure 14, sous la forme d'ondes évanescentes traversant le substrat 12.

Le guide d'ondes 16 s'étend à une distance non nulle de la face supérieure 18 du substrat 12 et de la nervure 14.

La distance séparant le guide d'ondes 16 de la nervure 14, mesurée selon la direction d'empilement Z, varie selon la direction d'étendue X.

La distance séparant le guide d'ondes 16 de la nervure 14 est suffisamment faible pour qu'une partie de l'onde électromagnétique se propageant dans la nervure soit captée par le guide d'ondes 16 sous forme d'onde évanescente, à travers le substrat 12 isolant.

Le guide d'ondes 16 est également propre à guider l'onde électromagnétique recueillie selon la direction de guidage X', à l'écart de la nervure 14.

Le guide d'ondes 16 présente une forme prismatique de section rectangulaire dans un plan orthogonal à la direction de guidage X'.

La direction de guidage X' forme un angle de couplage $\alpha$ avec la direction d'étendue X, dans un plan XZ parallèle à la direction de guidage X et à la direction d'empilement Z.

L'angle de couplage $\alpha$ est choisi de façon à améliorer un couplage entre la nervure 14 et le guide d'ondes 16, c'est-à-dire de façon à optimiser la transmission d'ondes évanescentes à travers le substrat 12, depuis la nervure 14 jusqu'au guide d'ondes 16.

L'angle de couplage $\alpha$ est, par exemple, compris entre -15° et 15°.

Le fonctionnement du laser 10 va maintenant être décrit.

Un même premier potentiel électrique est appliqué aux contacts latéraux 42 et un même deuxième potentiel électrique est appliqué aux contacts supérieurs 40, de façon à faire circuler un courant électrique des contacts latéraux 42 aux contacts supérieurs 40.

Le courant traverse la couche $C_2$, dopée P, puis parcourt la nervure 14 selon la direction d'empilement Z jusqu'à la couche $C_{N-1}$, dopée N.

Une onde électromagnétique se propage dans la nervure 14, en aller-retours selon la direction d'étendue X.

La différence d'indice de réfraction entre les matériaux composant la nervure 14 et le matériau isolant composant le substrat 12 permet le confinement du rayonnement lumineux dans la nervure 14.

Un pompage optique électrique a lieu au sein des puits quantiques formés par les couches $C_{2i}$ de la nervure 14, ce qui permet d'obtenir une amplification laser de certaines fréquences de l'onde électromagnétique se propageant dans la nervure 14, dans la bande de fréquence d'intérêt.

La répartition des orifices 36 le long de la partie centrale 30 permet de modifier le parcours du courant le long de la nervure 14, ce qui répartit les fréquences amplifiées selon un spectre multimodes équidistants en fréquences.

Les couches absorbantes $C_1$ et $C_N$ absorbent les parties de l'onde électromagnétique dont l'intensité est faible, c'est-à-dire les fréquences ne bénéficiant pas du pompage optique.

Les fréquences désirées de l'onde électromagnétique se propageant dans la nervure 14 sont ainsi amplifiées par un effet de cascade, ce qui permet d'obtenir une onde électromagnétique présentant une pluralité de modes equi-espacés en fréquence.

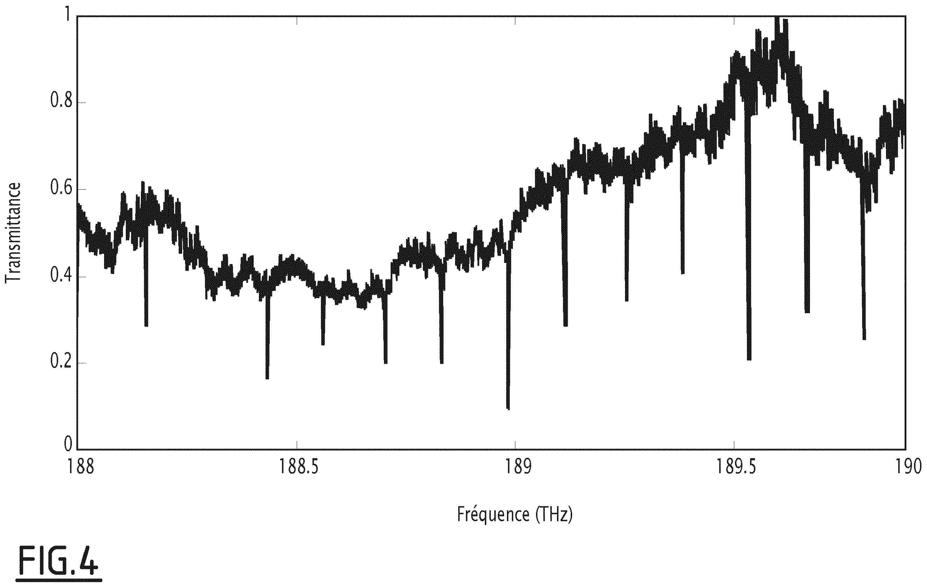

Un exemple de spectre de transmission obtenu expérimentalement est représenté sur la figure 4, et présente les résonances équi-espacées en fréquence désirées pour une impulsion laser multimode synchronisée en phase.

Une partie de l'onde électromagnétique traverse le substrat 12 sous forme d'onde évanescente pour rejoindre le guide d'ondes 16, puis est guidée par le guide d'ondes 16 à l'écart de la nervure 14, selon la direction de guidage X'.

Le laser 10 décrit est apte à émettre des impulsions laser multimodes synchronisées en phase, tout en présentant une structure fortement miniaturisée.

Cela permet d'avoir une bonne intégration du laser 10 sur une structure en silicium en présentant un encombrement très réduit. De plus, la miniaturisation du laser 10 permet d'avoir une consommation énergétique très faible, ce qui est un avantage important en optique intégrée.

Les impulsions laser comprennent plusieurs modes équi-espacés en fréquence avec une grande précision et une bonne régularité. Ces caractéristiques sont très avantageuses en métrologie par exemple.

Cela permet au laser 10 d'émettre un train d'impulsions gaussiennes proches de la gaussienne idéale, avec des taux de répétition proches de 100 GHz, ce qui permet, par exemple, d'obtenir des débits de données importants pour des communications optiques sur puce.

Les couches absorbantes permettent au laser 10 de se verrouiller de manière passive. Le verrouillage du laser 10 est robuste et peu sensible aux effets de bord.

En outre, le laser 10 est aisé à fabriquer, notamment par une technique de dépôt de couches minces pour la partie en matériau III-V et suivant des procédés de gravure communément utilisés pour la fabrication des diodes laser. La partie en matériau III-V est collée au substrat 12, réalisé par une fonderie de silicium pour la photonique.

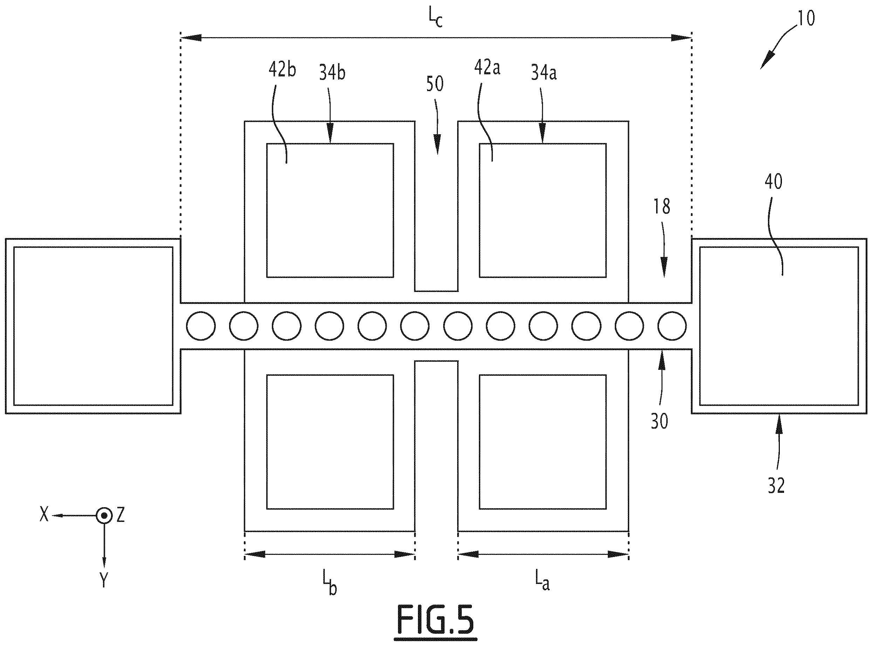

Un laser 10 est représenté sur la figure 5.

Le laser 10 présente une structure et un fonctionnement similaire au laser 10 décrit précédemment, à l'exception de ce qui suit.

La nervure 14 du laser 10 ne comprend pas de première couche absorbante et de deuxième couche absorbante.

La couche inférieure s'étend directement sur la face supérieure 18 du substrat 12.

Les contacts supérieurs 40 s'étendent directement sur la couche supérieure.

Le laser 10 comprend deux sillons 50 s'étendant selon la direction transversale Y, à travers les prolongements latéraux, de part et d'autre de la nervure 14.

Chaque sillon 50 est un segment isolant allongé, traversant toute l'épaisseur du prolongement latéral, selon la direction d'empilement Z, jusqu'à la face supérieure 18 du substrat 12.

Chaque prolongement latéral 34 est divisé en deux régions 34a, 34b distinctes, par un des sillons 50, comprenant une première région 34a de longueur $L_a$, mesurée selon la direction d'étendue X, et une deuxième région 34b de longueur $L_b$, mesurée selon la direction d'étendue X.

Les longueurs $L_a$ et $L_b$ sont, par exemple, égales l'une à l'autre.

Chaque contact latéral 42 est également divisé en un premier terminal 42a s'étendant sur la première région 34a et un deuxième terminal 42b s'étendant sur la deuxième région 34b.

Le premier terminal 42a et le deuxième terminal 42b de chaque contact latéral 42 sont distincts l'un de l'autre et disjoints, de façon à pouvoir être mis en contact électrique avec deux électrodes différentes et portés à deux potentiels électriques différents.

Cela permet de mettre en oeuvre un pompage optique électrique asymétrique. Une partie de la nervure 14 constitue un milieu à gain tandis qu'une autre partie reste absorbante, ce qui permet de réaliser la fonction d'absorbant saturable comme décrit plus haut.

D'autres modes de réalisation du laser 10 sont envisageables et présentent des avantages identiques à ceux du laser 10 décrit précédemment.

Selon un mode de réalisation, l'angle de couplage $\alpha$ est nul, et la direction de guidage X' est parallèle à la direction d'étendue X. La distance séparant le guide d'ondes 16 de la nervure 14, mesurée selon la direction d'empilement Z, est alors constante selon la direction d'étendue X.

Selon un mode de réalisation, les longueurs $L_a$ et $L_b$, respectivement de la première région 34a et de la deuxième région 34b de chaque prolongement latéral 34, sont différentes l'une de l'autre.

Selon un mode de réalisation, les prolongements latéraux 34 sont divisés en trois ou plus parties distinctes, par une pluralité de sillons 50 comme décrits précédemment, s'étendant selon la direction transversale Y, chaque partie présentant un contact respectif. Cela permet de mettre en oeuvre un pompage optique asymétrique mieux contrôlé.

Selon un mode de réalisation, la nervure 14 comprend un unique prolongement latéral 34, s'étendant d'un seul côté de la partie centrale 30, et un unique contact latéral 42 s'étendant sur le prolongement latéral.

Selon un mode de réalisation, le guide d'ondes 16 présente une largeur, mesurée selon la direction transversale Y, qui varie selon la direction de guidage X'. La variation de la largeur du guide d'ondes 16 est ajustée pour améliorer le couplage entre la nervure 14 et le guide d'ondes 16 aux différents modes de résonance.

Les modes de réalisations décrits peuvent être combinés selon toute configuration techniquement réalisable.


**Revendications**

**1.** Laser (10) à verrouillage de mode comprenant :

    - un substrat (12) isolant,
    - une nervure (14) s'étendant sur le substrat (12) selon une direction d'étendue (X), la nervure (14) formant une cavité résonante pour au moins une onde électromagnétique,

    - un guide d'ondes (16) défini dans le substrat (12), s'étendant selon une direction de guidage (X'),

la nervure (14) comprenant une couche inférieure ($C_2$), une pluralité de couches intermédiaires ($C_3$ à $C_{N-2}$) et une couche supérieure ($C_{N-1}$), empilées selon une direction d'empilement (Z) orthogonale à la direction d'étendue (X),

la cavité résonante étant propre à accueillir une pluralité de modes de résonnance équidistants en fréquence,

la nervure (14) présentant une pluralité d'orifices (36) traversants alignés selon la direction d'étendue (X),

le guide d'ondes (16) étant séparé de la nervure (14) par une distance non nulle selon la direction d'empilement (Z),

chaque orifice (36) étant séparé de chaque orifice (36) voisin par un écartement, les écartements présentant chacun une dimension, mesurée selon la direction d'étendue (X), qui varie selon la direction d'étendue (X) selon une loi de variation, la loi de variation étant une fonction polynomiale symétrique d'ordre supérieur ou égal à 4 d'une position de l'écartement (36) selon la direction d'étendue (X).

**2.** Laser selon la revendication 1, dans lequel la fonction polynomiale est d'ordre quatre, et est décrite par une formule du type :

$$a_n = a(x_n) = a_0 + A x_n{}^2 + B x_n{}^4$$

où :

    - $a_n$ est la dimension de l'écartement séparant un des orifices (36), référencé par un indice n, de l'orifice (36) voisin, référencé par un indice n+1,
    - $x_n$ est la distance entre un orifice (36), référencé par l'indice 0, et l'orifice (36) référencé par l'indice n, et
    - A et B sont des constantes non-nulles.

**3.** Laser selon la revendication 2, dans lequel une valeur de A est choisie de manière à fixer une valeur d'un intervalle spectral libre de la cavité, une valeur de B étant choisie pour permettre d'obtenir les modes de résonance équidistants en fréquence de la cavité.

**4.** Laser selon l'une quelconque des revendications 1 à 3, dans lequel une partie centrale (30) de la nervure (14) accueillant les orifices (36) présente une longueur ($L_c$) mesurée selon la direction d'étendue (X), la longueur ($L_c$) de la partie centrale (30) étant suffisante pour que la cavité résonante soit apte à accueillir au moins six modes de résonance équidistants en fréquence, la longueur ($L_c$) de la partie centrale (30) étant notamment supérieure ou égale à 20 micromètres.

5. Laser selon l'une quelconque des revendications 1 à 4, dans lequel la couche inférieure ($C_2$) définit, selon une direction transversale (Y), des prolongements latéraux (34) s'étendant de part et d'autre des couches intermédiaires ($C_3$ à $C_{N-2}$) et de la couche supérieure ($C_{N-1}$), chaque prolongement latéral (34) recevant au moins un contact électrique (42).

6. Laser selon la revendication 5, dans lequel chaque prolongement latéral (34) comprend un sillon (50) isolant s'étendant à travers le prolongement latéral (34) selon la direction transversale (Y), de manière à diviser le prolongement latéral (34) en deux régions (34a, 34b) voisines selon la direction d'étendue (X), isolées électriquement l'une de l'autre, chaque région (34a, 34b) recevant un contact électrique (42a, 42b) respectif distinct.

7. Laser selon l'une quelconque des revendications 1 à 5, dans lequel la nervure (14) comprend également une première couche absorbante ($C_1$) s'étendant en-dessous de la couche inférieure ($C_2$) selon la direction d'empilement (Z), et une deuxième couche absorbante ($C_N$) s'étendant au-dessus de la couche supérieure ($C_{N-1}$) selon la direction d'empilement (Z), la première couche absorbante ($C_1$) et la deuxième couche absorbante ($C_N$) comprenant un matériau absorbant saturable à au moins une fréquence de résonance de la nervure (14).

8. Laser selon l'une quelconque des revendications 1 à 7, dans lequel la direction de guidage (X') forme un angle de couplage ($\alpha$) non-nul avec la direction d'étendue (X), dans le plan horizontal (XY).

9. Laser selon la revendication 7 ou 8, dans lequel le guide d'ondes (16) présente une largeur (W) variable le long de la direction de guidage (X'), mesurée selon une direction orthogonale à la direction de guidage (X').

10. Composant optique comprenant un laser (10) selon l'une quelconque des revendications 1 à 9.


**Patentansprüche**

1. Laser (10) mit Modusverriegelung, umfassend:

   - ein isolierendes Substrat (12),

   - eine Rippe (14), die sich in einer Erstreckungsrichtung (X) auf dem Substrat (12) erstreckt, wobei die Rippe (14) einen Resonanzhohlraum für mindestens eine elektromagnetische Welle bildet,
   - einen Wellenleiter (16), der in dem Substrat (12) definiert ist und sich entlang einer Führungsrichtung (X') erstreckt,
   die Rippe (14), umfassend eine untere Schicht ($C_2$), eine Vielzahl von Zwischenschichten ($C_3$ à $C_{N-2}$) und eine obere Schicht ($C_{N-1}$), die in einer Stapelrichtung (Z) orthogonal zu der Erstreckungsrichtung (X) gestapelt sind,
   wobei der Hohlraumresonator geeignet ist, um eine Vielzahl von frequenzmäßig äquidistanten Resonanzmodi aufzunehmen,
   die Rippe (14) eine Vielzahl von Durchgangslöchern (36) aufweist, die entlang der Erstreckungsrichtung (X) ausgerichtet sind,
   wobei der Wellenleiter (16) durch einen Abstand ungleich Null entlang der Stapelrichtung (Z) von der Rippe (14) getrennt ist,
   jede Öffnung (36) von jeder benachbarten Öffnung (36) durch einen Abstand getrennt ist, wobei die Abstände jeweils eine in der Erstreckungsrichtung (X) gemessene Abmessung aufweisen, die sich in der Erstreckungsrichtung (X) gemäß einem Änderungsgesetz ändert, wobei das Änderungsgesetz eine symmetrische Polynomfunktion der Ordnung größer als oder gleich wie 4 einer Position des Abstands (36) in der Erstreckungsrichtung (X) ist.

2. Laser nach Anspruch 1, wobei die Polynomfunktion von der Ordnung vier ist und durch eine Formel folgenden Typs beschrieben ist:

$$a_n = a(x_n) = a_0 + Ax_n^2 + Bx_n^4$$

wobei:

   - $a_n$ die Größe des Abstands ist, der eine der Öffnungen (36), die mit einem Index n bezeichnet wird, von der benachbarten Öffnung (36), die mit einem Index n+1 bezeichnet wird, trennt,
   - $x_n$ der Abstand zwischen einer Öffnung (36), die mit dem Index 0 bezeichnet ist, und der Öffnung (36), die mit dem Index n bezeichnet ist, ist, und
   - A und B sind Konstanten ungleich null sind.

3. Laser nach Anspruch 2, wobei ein Wert von A gewählt ist, um einen Wert eines freien Spektralintervalls des Hohlraums festzulegen, wobei ein Wert von B gewählt ist, um zu ermöglichen, die frequenzmäßig äquidistanten Resonanzmodi des Hohlraums zu erlangen.

**4.** Laser nach einem der Ansprüche 1 bis 3, wobei ein mittlerer Teil (30) der Rippe (14), die die Öffnungen (36) aufnimmt, eine Länge ($L_c$), gemessen in der Erstreckungsrichtung (X), aufweist, wobei die Länge ($L_c$) des mittleren Teils (30) ausreichend ist, damit der Resonanzhohlraum mindestens sechs frequenzmäßig äquidistante Resonanzmodi aufnehmen kann, wobei die Länge ($L_c$) des mittleren Teils (30) insbesondere größer als oder gleich wie 20 Mikrometer ist.

**5.** Laser nach einem der Ansprüche 1 bis 4, bei dem die untere Schicht ($C_2$) in einer Querrichtung (Y) seitliche Verlängerungen (34) definiert, die sich auf beiden Seiten der Zwischenschichten ($C_3$ bis $C_{N-2}$) und der oberen Schicht ($C_{N-1}$) erstrecken, wobei jede seitliche Verlängerung (34) mindestens einen elektrischen Kontakt (42) aufnimmt.

**6.** Laser nach Anspruch 5, wobei jede seitliche Verlängerung (34) eine isolierende Rille (50) aufweist, die sich in der Querrichtung (Y) durch die seitliche Verlängerung (34) erstreckt, um die seitliche Verlängerung (34) in zwei Bereiche (34a, 34b) zu unterteilen, die elektrisch voneinander isoliert sind, wobei jeder Bereich (34a, 34b) einen jeweiligen separaten elektrischen Kontakt (42a, 42b) aufnimmt.

**7.** Laser nach einem der Ansprüche 1 bis 5, wobei die Rippe (14) auch eine erste absorbierende Schicht ($C_1$), die sich unterhalb der unteren Schicht ($C_2$) in der Stapelrichtung (Z) erstreckt, und eine zweite absorbierende Schicht ($C_N$), die sich oberhalb der oberen Schicht ($C_{N-1}$) in der Stapelrichtung (Z) erstreckt, umfasst, wobei die erste absorbierende Schicht ($C_1$) und die zweite absorbierende Schicht ($C_N$) ein absorbierendes Material umfassen, das bei mindestens einer Resonanzfrequenz der Rippe (14) sättigbar ist.

**8.** Laser nach einem der Ansprüche 1 bis 7, wobei die Führungsrichtung (X') in der horizontalen Ebene (XY) einen Kopplungswinkel ($\alpha$) ungleich Null mit der Erstreckungsrichtung (X) bildet.

**9.** Laser nach Anspruch 7 oder 8, wobei der Wellenleiter (16) eine Breite (W) aufweist, die entlang der Führungsrichtung (X') variabel ist, gemessen in einer Richtung orthogonal zu der Führungsrichtung (X').

**10.** Optische Komponente, umfassend einen Laser (10) nach einem der Ansprüche 1 bis 9.

**Claims**

**1.** Mode-locked laser (10) comprising:

- an insulating substrate (12),
- a rib (14) extending over the substrate (12) in an extended direction (X), the rib (14) forming a resonant cavity for at least one electromagnetic wave,
- a waveguide (16) defined in the substrate (12), extending in a guiding direction (X'), the rib (14) comprising a lower layer ($C_2$), a plurality of intermediate layers ($C_3$ to $C_{N-2}$) and a top layer ($C_{N-1}$), stacked in a stacking direction (Z) orthogonal to the direction of extent (X),

the resonant cavity being able to accommodate a plurality of resonance modes equidistant in frequency,

the rib (14) having a plurality of through-apertures (36) aligned in the direction of extension (X),

the waveguide (16) being separated from the rib (14) by a non-zero distance in the stacking direction (Z),

each orifice (36) being separated from each adjacent orifice (36) by a spacing, the spacings each having a dimension, measured in the direction of extension (X), which varies in the direction of extension (X) according to a law of variation, the law of variation being a symmetrical polynomial function of order greater than or equal to 4 of a position of the spacing (36) in the direction of extension (X).

**2.** Laser according to claim 1, in which the polynomial function is of order four, and is described by a formula of the type:

$$a_n = a(x_n) = a_0 + Ax_n{}^2 + Bx_n{}^4$$

where:

- $a_n$ is the dimension of the gap separating one of the orifices (36), referenced by an index n, from the adjacent orifice (36), referenced by an index n+1,
- $x_n$ is the distance between an orifice (36), referenced by the subscript 0, and the orifice (36) referenced by the subscript n, and
- A and B are non-zero constants.

**3.** Laser according to claim 2, in which a value of A is chosen so as to fix a value of a free spectral interval of the cavity, a value of B being chosen so as to make it possible to obtain the resonance modes equidistant in frequency from the cavity.

**4.** Laser according to any one of claims 1 to 3, in which a central part (30) of the rib (14) accommodating the orifices (36) has a length ($L_c$) measured along the direction of extent (X), the length ($L_c$) of the central part (30) being sufficient for the resonant cavity to be able to accommodate at least six frequency-equidistant resonance modes, the length ($L_c$) of the central part (30) being in particular greater than or equal to 20 micrometres.

5. Laser according to any one of claims 1 to 4, in which the lower layer ($C_2$) defines, in a transverse direction (Y), lateral extensions (34) extending on either side of the intermediate layers ($C_3$ to $C_{N-2}$) and the upper layer ($C_{N-1}$), each lateral extension (34) receiving at least one electrical contact (42).

6. Laser according to claim 5, wherein each lateral extension (34) comprises an insulating groove (50) extending through the lateral extension (34) in the transverse direction (Y), so as to divide the lateral extension (34) into two regions (34a, 34b) adjacent in the direction of extent (X), electrically insulated from each other, each region (34a, 34b) receiving a separate respective electrical contact (42a, 42b).

7. Laser according to any one of claims 1 to 5, wherein the rib (14) also comprises a first absorbent layer ($C_1$) extending below the lower layer ($C_2$) in the stacking direction (Z), and a second absorbent layer ($C_N$) extending above the upper layer ($C_{N-1}$) in the stacking direction (Z), the first absorbent layer ($C_1$) and the second absorbent layer ($C_N$) comprising a absorbent material that can be saturated at at least one resonant frequency of the rib (14).

8. Laser according to any one of claims 1 to 7, in which the guidance direction (X') forms a non-zero coupling angle ($\alpha$) with the direction of extension (X), in the horizontal plane (XY).

9. Laser according to claim 7 or 8, in which the waveguide (16) has a width (W) that varies along the guiding direction (X'), measured in a direction orthogonal to the guiding direction (X').

10. Optical component comprising a laser (10) according to any one of claims 1 to 9.

## FIG.1

FIG.2

FIG.3

FIG.4

EP 4 055 670 B1

**FIG.5**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2016207495 A